# FASCICULE DE BREVET EUROPEEN

(11) **EP 1 596 206 B1**
(45) Date de publication et mention de la délivrance du brevet: **28.05.2008**
(21) Numéro de dépôt: 05354015.9
(22) Date de dépôt: 17.03.2005
(51) Int. Cl.: G01R 15/18

(54) **Dispositif de mesure d'un courant électrique, capteur de courant, déclencheur électrique et dispositif de coupure comportant un tel dispositif de mesure**
Elektrische Strommessanordnung, Stromsensor, elektrischer Auslöser und Trennschalter mit einer derartigen Strommessanordnung
Electric current measuring arrangement, current sensor, electric tripping device and circuit breaker comprising such a current measuring device

(30) Priorité: 13.05.2004 FR 0405199
(43) Date de publication de la demande: 16.11.2005
(73) Titulaire: SCHNEIDER ELECTRIC INDUSTRIES SAS, 92500 Rueil-Malmaison (FR)
(72) Inventeur: Houbre, Pascal, 38050 Grenoble Cedex 09 (FR); Budillon, Gilles, 38050 Grenoble Cedex 09 (FR); Buffat, Sébastien, 38050 Grenoble Cedex 09 (FR); Toti-Buttin, Frédéric, 38050 Grenoble Cedex 09 (FR)
(74) Mandataire: Tripodi, Paul

(56) Documents cités:
- EP-A- 0 209 415
- EP-A- 0 838 686
- FR-A- 2 507 811
- US-A- 5 012 218
- US-B1- 6 295 190

## Description

### DOMAINE TECHNIQUE DE L'INVENTION

L'invention est relative à un dispositif de mesure de courant de type Rogowski comportant au moins trois bobinages reliés électriquement en série et formant un contour polygonal fermé destiner à entourer un conducteur pour effectuer une mesure du courant.

### ETAT DE LA TECHNIQUE

L'utilisation de dispositif de mesure de courant comportant des capteurs inductifs de type Rogoswki est largement décrit dans la littérature.

Les dispositifs de mesure de courant de type Rogoswki comprennent un support en matériau amagnétique placé autour d'un conducteur ou ligne de courant dans lequel circule le courant à mesurer. Un fil conducteur est bobiné sur le support pour former un enroulement secondaire. L'ensemble forme un transformateur où ledit conducteur ou ligne de courant constitue un enroulement primaire et ledit enroulement secondaire fournit un signal de mesure. La tension fournie aux bornes de l'enroulement secondaire est directement proportionnelle à l'intensité du courant électrique circulant dans le conducteur ou ligne de courant. L'absence de noyau magnétique risquant d'être saturé, permet une large dynamique de mesure.

Afin d'obtenir une mesure de tension indépendante de la position du conducteur dans le support et pour supprimer l'influence d'un autre conducteur placé à l'extérieur du support, il est nécessaire que le nombre de spires par unité de longueur soit constant sur toute la longueur du bobinage et que les spires soient jointives.

Certaines solutions (US4611191, WO01/57543 A1) comportent des bobinages sous la forme de solénoïdes toriques. Le fil électrique peut être alors bobiné sur un support non-conducteur torique de section circulaire ou rectangulaire. Bien que très efficace, les solutions utilisant un tore fermé restent difficiles à industrialiser du fait de la géométrie du tore. En effet, le bobinage d'un tore reste complexe et ceci est particulièrement vrai lorsque la taille du dispositif de mesure de courant est réduite. La solution US5012218 décrit un dispositif de mesure de type Rogowski comportant un seul bobinage sous la forme d'un solénoïde torique. Le bobinage est constitué d'un tore ouvert dont le nombre de spires par unité de longueur est constant. Des bobines de compensation sont alors ajoutées afin de compenser les effets néfastes dus à l'ouverture. Le dispositif de mesure est nécessairement ouvert afin de pouvoir y introduire ou y retirer le conducteur sur lequel on fait la mesure.

Afin de remédier à ces problèmes de réalisation, d'autres solutions consistent à utiliser un ensemble de plusieurs bobines reliées électriquement en série et disposées selon un contour polygonal. Chaque coté du polygone est alors constitué d'un bobinage linéaire ou quasi-linéaire. De manière globale, plus le nombre de bobinages utilisés est grand, plus la forme générale du polygone se rapproche de celle d'un tore cylindrique (US32626291, DE19731170).

Afin d'optimiser la réalisation industrielle du polygone, des solutions utilisant des contours polygonaux à quatre cotés de forme carrée ou rectangulaire peuvent être utilisées (EP209415, FR2507811, DE2432919). Tel que représenté sur la figure 1, le dispositif de mesure de courant 1 est alors constitué de quatre bobinages 2 linaires reliés électriquement en série et dont les axes longitudinaux Y sont placés selon un même plan radial. Le conducteur primaire 7 sur lequel est effectuée la mesure de courant, est placé à l'intérieur du dispositif de mesure de courant selon une direction perpendiculaire audit plan radial du dispositif de mesure de courant 1.

Cependant, ces solutions présentent parfois l'inconvénient d'être trop sensibles à des phénomènes extérieurs au polygone. La mesure du courant circulant dans le conducteur 7 peut être ainsi faussée.

En effet, lorsque plusieurs bobinages 2 sont utilisés pour constituer un dispositif de mesure de courant fermé de forme polygonale, il existe une zone de discontinuité magnétique H vers chaque liaison entre deux bobinages 2. Contrairement à un dispositif de mesure de courant comportant un solénoïde de forme torique parfaite, le nombre de spires par unité de longueur n'est plus constant sur toute la longueur du bobinage du dispositif de mesure. Il existe une discontinuité structurelle du fait que la dernière spire d'un bobinage 2 n'est pas jointive avec la première spire du bobinage 2 qui lui est directement connecté. Le coefficient de mutuelle induction M0 entre le dispositif de mesure de courant et un circuit extérieur n'est pas nulle.

Cette discontinuité structurelle entre deux bobinages est d'autant plus grande que l'angle interne α formé entre deux bobinages du polygone est faible. Les angles internes α entre les bobinages d'un dispositif de mesure de courant de forme polygonale carrée ou rectangulaire sont de 90 degrés.

Certaines solutions de l'état de la technique (EP0838686) compensent ces discontinuités en agençant les quatre bobinages de manière à ce que chaque extrémité de bobinage soit recouverte partiellement ou totalement par le bobinage qui lui est adjacent. Cette solution ne répond pas entièrement au problème lié à l'influence de flux extérieurs sur la mesure de courant. En outre, on rencontre des problèmes d'implantation des bobinages sur leur support.

D'autres solutions utilisent des morceaux de noyaux magnétiques placés uniquement au niveau des discontinuités structurelles. Bien que réduisant l'influence des flux parasites extérieurs, ces noyaux finissent tout de même par saturer en présence de forts courants. En outre, la présence de ces noyaux rend plus complexe la connexion des bobinages entre eux.

### EXPOSE DE L'INVENTION

L'invention vise donc à remédier aux inconvénients de l'état de la technique, de manière à proposer un dispositif de mesure de courant électrique moins sensible aux perturbations extérieures, de volume réduit, et d'industrialisation simplifiée.

Un dispositif de mesure de courant pour un capteur courant mixte selon l'invention comprend des bobinages dont l'inductance locale d'au moins une des extrémités desdits bobinages est supérieure à l'inductance locale vers la partie centrale desdits bobinages.

Avantageusement, l'inductance locale aux deux extrémités desdits bobinages est supérieure à l'inductance locale vers la partie centrale desdits bobinages.

Avantageusement, les extrémités des bobinages dont l'inductance locale est supérieure à l'inductance locale de la partie centrale, comportent un nombre de spires de fil par unité de longueur supérieur au nombre de spires de fil par unité de longueur vers la partie centrale desdits bobinages.

Avantageusement, les extrémités comportent un nombre de couches de spires de fil supérieur au nombre de couches de spires de fil vers la partie centrale desdits bobinages, le pas de l'enroulement des spires étant constant.

Dans un mode de réalisation particulier, les extrémités comportent sur une même couche de spires, un pas d'enroulement des spires inférieur au pas de l'enroulement des spires vers la partie centrale desdits bobinages.

De préférence, la variation du nombre de spires aux deux extrémités des bobinages est pratiquée sur une distance comprise entre 10 et 20 pour cent de la longueur totale du bobinage.

Selon un mode de développement de l'invention, les extrémités des bobinages dont l'inductance locale est supérieure à l'inductance locale de la partie centrale comportent des spires de longueur supérieure à celle des spires vers la partie centrale desdits bobinages.

Dans un mode de réalisation particulier, les surfaces radiales des extrémités de deux bobinages sont partiellement recouvertes par les bobinages adjacents.

De préférence, le dispositif de mesure de courant est constitué de quatre bobinages agencés de façon à former un contour fermé.

Avantageusement, ledit contour a une forme polygonale carrée ou rectangulaire.

Un capteur de courant mixte comprenant un capteur de courant magnétique ayant un bobinage enroulé autour d'un circuit magnétique, possède un dispositif de mesure de courant tel que défini ci-dessus disposé de manière à ce que le circuit primaire dudit capteur magnétique corresponde au circuit primaire dudit dispositif de mesure de courant.

Un déclencheur électrique comprend des moyens de traitement connectés à au moins un dispositif de mesure de courant tel que défini ci-dessus pour recevoir au moins un signal représentatif d'un courant primaire.

Un dispositif de coupure comprenant un mécanisme d'ouverture de contacts électriques et un relais relié à un déclencheur tel que défini ci-dessus, le déclencheur comporte un dispositif de mesure de courant tel que défini ci-dessus.

### BREVE DESCRIPTION DES FIGURES

D'autres avantages et caractéristiques ressortiront plus clairement de la description qui va suivre d'un mode particulier de réalisation de l'invention, donné à titre d'exemple non limitatif, et représenté aux dessins annexés sur lesquels :
- la figure 1 représente une vue de dessus d'un dispositif de mesure de courant de type connu ;
- la figure 2 représente une vue de dessus schématique du dispositif de mesure de courant à quatre bobinages selon un mode préféré de réalisation de l'invention ;
- la figure 3 représente une vue agrandie de la figure 2 correspondant à la zone de jonction de deux bobinages ;
- la figure 4 représente une vue de coté du dispositif de mesure de courant selon la figure 2 ;
- les figures 5 à 7 représentent des variantes de réalisation du dispositif de mesure de courant selon la figure 2 ;
- les figures 8 à 10 représentent des vues en perspective des bobinages en cours d'assemblage sur le support ;
- La figure 11 représente un mode préférentiel de réalisation d'un capteur de courant mixte selon l'invention;
- La figure 12 représente un schéma bloc d'un dispositif de coupure intégrant des capteurs de courant selon l'invention.

### DESCRIPTION DETAILLEE D'UN MODE DE REALISATION

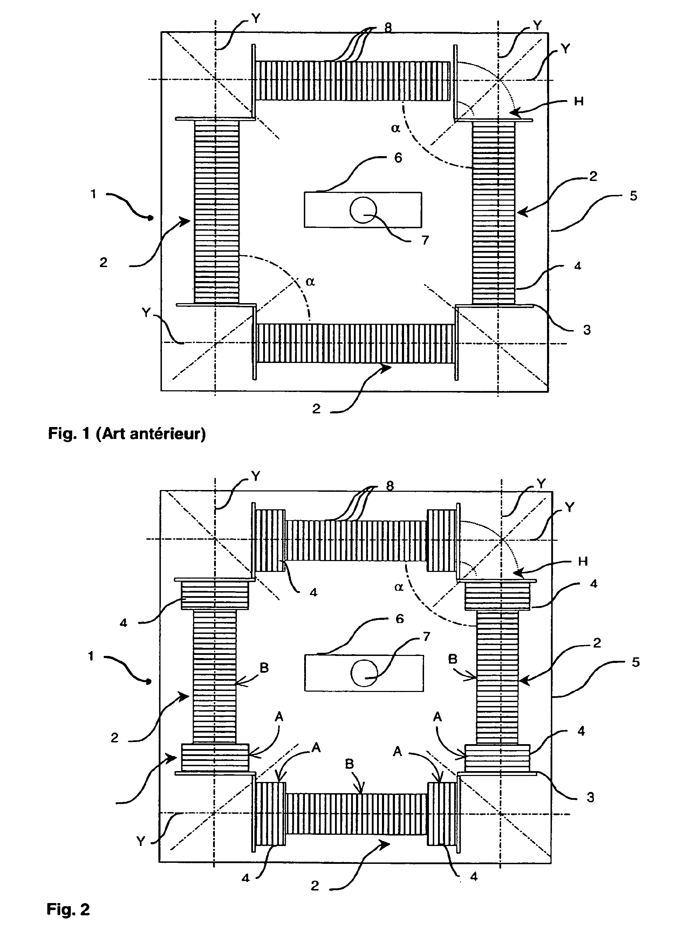

Le dispositif de mesure de courant 1 comporte au moins trois bobinages 2 linéaires reliés électriquement en série et formant un contour polygonal fermé. Selon le mode de réalisation préféré de l'invention représenté sur la figure 2, le dispositif de mesure de courant 1 comporte quatre bobinages 2 linéaires disposés sur un même plan. L'axe longitudinal Y de chaque bobinage est perpendiculaire aux axes longitudinaux respectifs des deux bobinages placés physiquement à coté.

Chaque bobinage est composé une carcasse de forme linéaire, creuse, en matériau amagnétique, rigide ou semi-rigide, de section cylindrique, carrée, rectangulaire ou ovoïde. Un fil métallique en cuivre ou en un alliage à base de cuivre est enroulé sur la carcasse.

Généralement, les carcasses des capteurs connus ont des sections de forme circulaire. Cependant, une telle forme ne permet pas d'avoir une section maximale lorsque l'espace ou le volume alloués aux capteurs sont limités. Dans l'exemple de réalisation, la section des carcasses des bobinages est de forme rectangulaire. Deux flasques 3 sont placés respectivement aux deux extrémités desdits bobinages 2.

Les bobinages 2 sont reliés électriquement en série entre eux. Chaque bobinage est fixé sur une embase 5 supportant l'ensemble des quatre bobinages. L'embase 5 est munie d'un évidemment central 6 permettant le passage du conducteur ou ligne de courant 7 sur lequel est effectuée la mesure du courant. Ce conducteur ou ligne de courant 7 forme le circuit primaire du dispositif de mesure de courant 1.

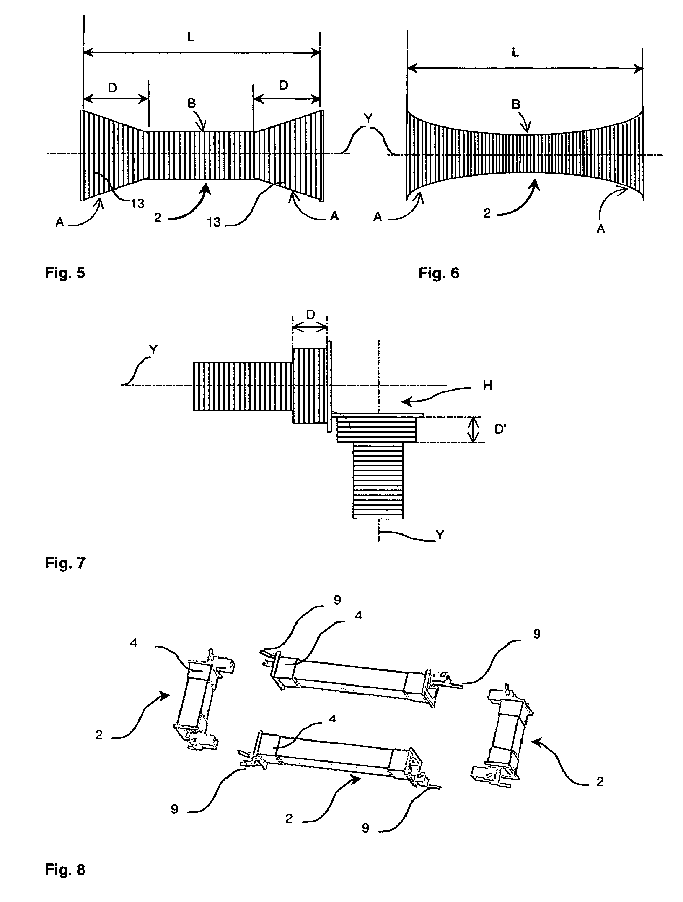

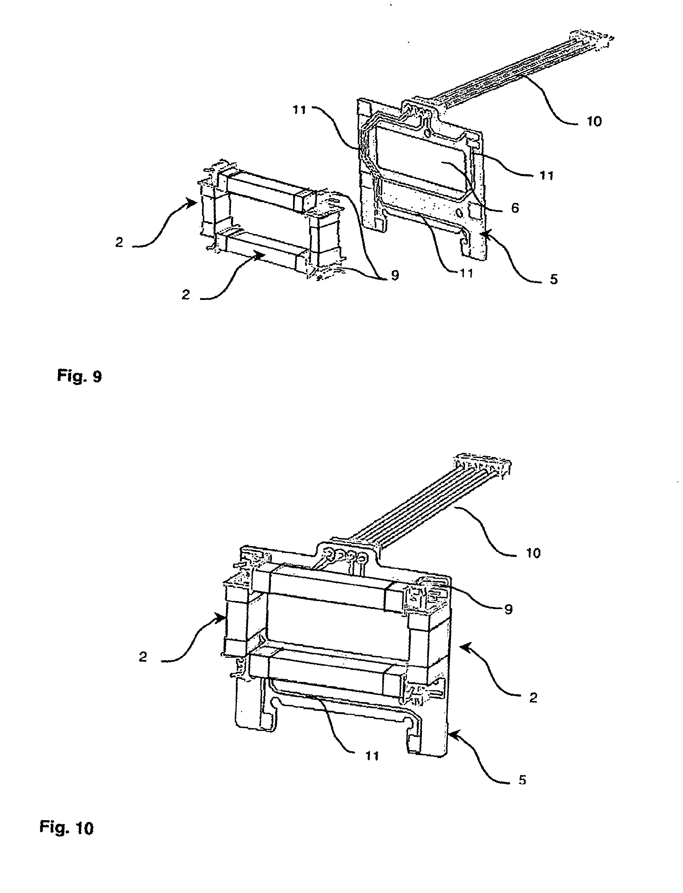

Dans le mode de réalisation tel que présenté sur les figures 8 à 10, l'embase 5 est constituée d'un circuit imprimé. Ce circuit assure alors à la fois la fixation mécanique des bobinages 2 et leur interconnexion électrique. Le circuit imprimé assure aussi les connexions externes à un bus de connexion 10. Les quatre bobinages 2 possèdent respectivement des picots de connexion 9 soudés directement sur les pistes 11 du circuit imprimé.

Chaque bobinage 2 peut comporter plusieurs couches de fil. L'enroulement du fil sur une même couche est réalisé à pas constant. Autrement dit, sur une couche, le nombre de spires 8 par unité de longueur est constant. En outre, préférentiellement, les spires sont jointives.

Chaque bobinage 2 porte, soit un nombre pair de couches de fil, auquel cas les picots de connexion 9 sont situés d'un même coté de la carcasse de bobinage ; soit un nombre impair de couches de fil, auquel cas les picots de connexion 9 sont situés de part et d'autre de la carcasse. Dans le premier cas, les pistes 11 conductrices d'interconnexion de picots de connexion 9 de bobinages voisins ont une longueur sensiblement équivalente de celle de la carcasse. Dans le second cas le circuit imprimé porte avantageusement une piste conductrice de neutralisation entourant sensiblement l'évidement central 6. Cette piste est disposée électriquement en série et magnétiquement en opposition avec les enroulements de manière à neutraliser les effets perturbateurs des champs magnétiques extérieurs.

Du fait de cette disposition en carré des quatre bobinages 2, il existe implicitement quatre zones H de discontinuité structurelle où aucune spire 8 n'est présente. Les angles internes α formés entre les bobinages du polygone sont alors de 90 degrés.

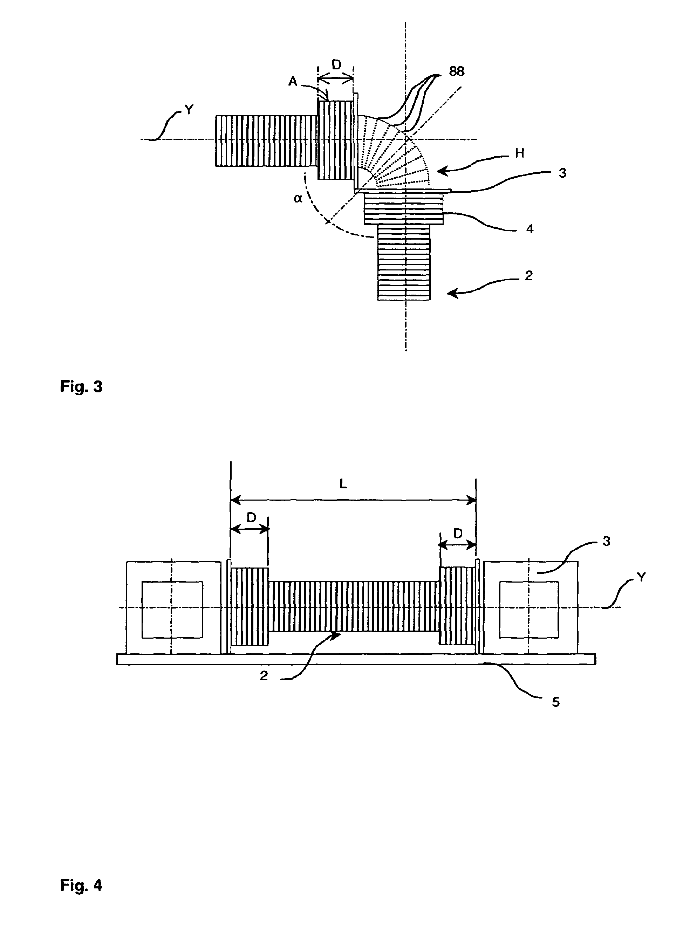

Idéalement, comme cela est schématisé sur la figure 3, des spires 88 devraient être disposées dans la zone H afin d'éviter toute discontinuité de bobinage sur le périmètre du capteur. Le nombre de spires par unité de longueur sur ces portions d'arc resterait ainsi proche à celui des portions linaires.

Afin de limiter les effets néfastes dus au manque de spires sur ces portions du capteur, l'invention consiste à positionner sur le capteur des moyens de compensation des zones de discontinuité. Ces moyens de compensation consistent à changer localement l'inductance des bobinages vers leurs extrémités respectives. En effet, les moyens de compensation tendent à augmenter localement l'inductance des bobinages 2 à leurs extrémités A. L'inductance locale aux extrémités A est alors supérieure à celle observée localement vers la partie centrale B desdits bobinages 2.

Ainsi, selon le mode préférentiel de réalisation de l'invention, le dispositif comporte des bobinages 2 avec des enroulements de spires complémentaires sur ses deux extrémités A. Dans cet exemple de réalisation, on pallie la discontinuité structurelle par une compensation électrique. Le nombre de spires 8 ajouter à chaque extrémité A est égal approximativement à 1/(racine de 2) fois le nombre spires manquantes dans la zone H. Les sur-bobinages 4 sont réalisés le plus proche possible des deux extrémités A. Dans l'exemple de réalisation, les sur-bobinages 4 sont pratiqués sur une distance D comprise préférentiellement entre dix et vingt pour cent de la longueur totale L du bobinage. L'enroulement du fil sur l'ensemble de chaque bobinage est de préférence réalisé à pas constant, par exemple à spires jointives.

Selon une première variante de réalisation, l'effet du sur-bobinage est remplacé par celui d'une variation du pas de bobinage du fil aux extrémités de chaque bobinage 2. En effet, sur une même couche de fil, le pas de bobinage observé localement aux deux extrémités A des bobinages est différent de celui observé localement vers la partie centrale B dudit bobinage. Le pas de bobinage du fil aux extrémités A est inférieure à celui existant localement vers la partie centrale B du bobinage. Ainsi, sans qu'il soit nécessaire d'augmenter le nombre de couches, le nombre de spires 8 de fil par unité de longueur observé localement aux extrémités A est supérieur au nombre de spires pas unité de longueur observée localement vers la partie centrale B du bobinage linaire 2.

Selon une seconde variante de réalisation telle que représentée sur les figures 5 et 6, la discontinuité structurelle peut être compensée par un changement de longueur de fil par spire de bobinage au niveau des extrémités A des bobinages 2. Chaque bobinage 2 est alors réalisé sur une carcasse amagnétique dont la section n'est pas constante sur toute sa longueur L. La section de la carcasse vers les deux extrémités A doit être supérieure à la section vers la partie centrale B. On peut envisager une carcasse composée de deux volumes tronconiques disposés de manière à ce que les grandes bases des cônes correspondent aux surfaces placées aux extrémités A de la carcasse. Une autre solution consisterait à utiliser une carcasse dont la section varie d'une extrémité A à l'autre suivant un profil correspondant à une portion de cercle ou de parabole.

Selon une autre variante de réalisation telle que représentée sur la figure 7, la discontinuité structurelle initiale est compensée d'une part par une augmentation de l'inductance locale vers les extrémités A des bobinages et d'autre part par un décalage spatial de deux bobinages. On combine donc une compensation électrique avec une compensation géométrique. Cette compensation géométrique consiste en effet à placer deux bobinages parallèles de telle manière à ce que leur extrémité A recouvre partiellement les surfaces radiales des bobinages adjacents.

Il peut bien sur être envisagé de combiner entre elles ces quatre mode de réalisation de l'invention. En effet, il peut par exemple être envisagé de prévoir des sur-bobinages aux extrémités A des bobinages 2 avec des enroulements qui possèdent des pas variables ou de prévoir des bobinages ayant des sections variables avec des enroulements à pas variables. Par ailleurs, un même dispositif de mesure de courant 1 peut comporter des bobinages réalisés respectivement avec des modes différents de réalisation décrits ci-dessus.

En outre, les solutions décrites ci-dessus prévoient que toutes les extrémités A de tous les bobinages 2 possèdent une inductance locale modifiée. La discontinuité entre deux bobinages 2 est ainsi compensée grâce à la modification structurelle et ou électrique des extrémités A respectives des deux bobinages 2. Il peut être aussi envisagé de modifier uniquement une seule extrémité A des deux extrémités A des deux bobinages 2. En pratique, sur l'ensemble des bobinages 2 du dispositif de mesure de courant 1, seule une extrémité A sur deux possédera une inductance locale modifiée.

De manière générale, les effets néfastes ou perturbations extérieures se font d'autant plus ressentir sur la mesure de courant lorsque les zones de discontinuité H sont importantes. Autrement dit, plus l'angle interne α entre deux bobinages est petit, par exemple inférieur de 90 degrés, plus la zone de discontinuité structurelle H est importante et plus les perturbations se feront ressentir. Ainsi, les moyens de compensation selon l'invention sont plus particulièrement destinés à des capteurs de courant ayant des bobinages disposés sur un contour polygonal ayant moins de huit cotés. Pour des polygones ayant plus de huit cotés, les zones de discontinuité H étant relativement faibles, la nécessité d'y adjoindre des moyens de compensation se fait moins ressentir.

Le dispositif de mesure de courant 1 selon les différents modes de réalisation de l'invention, est particulièrement destiné à être combiné à un capteur magnétique de courant formant ainsi un capteur de courant mixte 20 composée d'un capteur magnétique et d'un dispositif de mesure de courant 1 de type Rogowski.

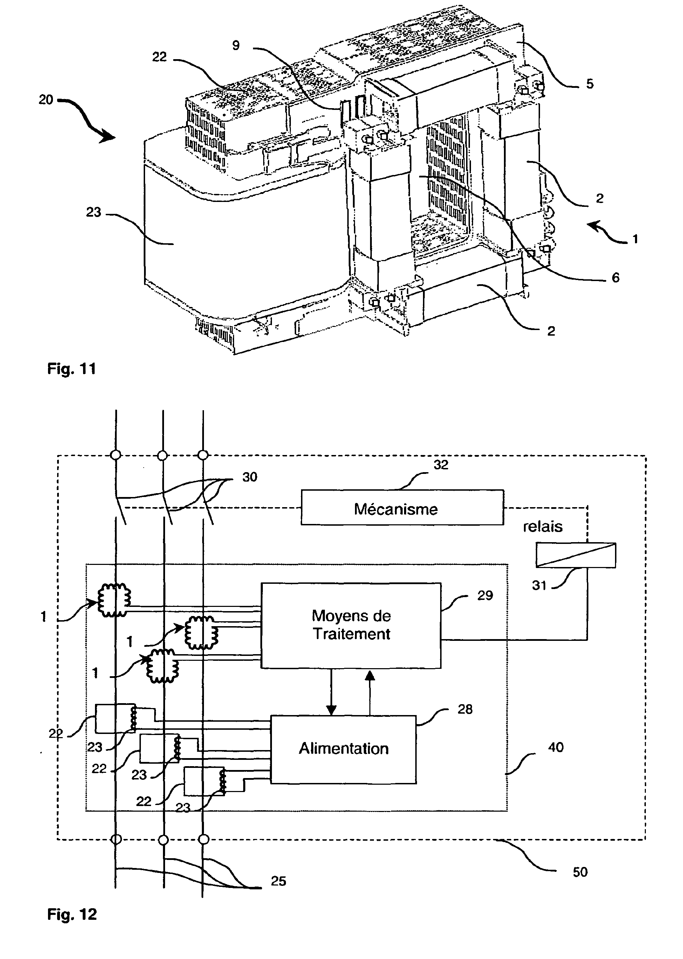

Cet ensemble 20 peut être alors intégré dans un déclencheur électrique 40 destiné à commander un dispositif de coupure tel qu'un disjoncteur 50. Le disjoncteur 50 est monté sur des conducteurs ou lignes de courant électrique 25. Les capteurs magnétiques de courant sont alors connectés au boîtier d'alimentation 28 du déclencheur. Les dispositifs de mesure de courant 1 selon l'invention sont reliés aux moyens de traitement 29. Les moyens de traitement 29 sont eux-mêmes alimentés par le boîtier d'alimentation 28. Comme cela est représenté sur la figure 12, plusieurs pôles électriques d'une l'installation peuvent comporter chacun un dispositif de mesure de courant de type Rogoswki selon l'invention et un capteur magnétique de courant.

Si les moyens de traitement 29 reçoivent via les dispositifs de mesure de courant 1, une information de défaut présent sur au moins une des lignes 25, un ordre de commande d'ouverture des contacts 30 peut être envoyé au mécanisme d'ouverture 32 via le relais 31.

Comme cela est représenté sur la figure 11, le capteur magnétique de courant est essentiellement composé d'un bobinage 23 disposé sur un circuit magnétique 22 formant ainsi l'enroulement secondaire d'un transformateur de courant. Le circuit primaire est constitué par le conducteur ou ligne de courant électrique 25 sur laquelle est installé l'ensemble 20. Ce conducteur ou ligne de courant électrique 25, non représenté, est disposé à l'intérieur d'une ouverture 6 aménagée dans le circuit magnétique 22. En outre, selon ce mode réalisation, le circuit primaire du capteur magnétique de courant correspond aussi au circuit primaire du dispositif de mesure de courant 1 selon l'invention. En effet les quatre bobinages 2 linéaires montés en série et formant un carré sont disposés autour de l'ouverture 6 dans laquelle passe ledit conducteur ou liane de courant électrique 25. Le circuit imprimé 5 servant de support aux quatre bobinages est utilisé pour la connexion électrique desdits bobinages mais aussi pour la connexion électrique de la bobine 23. Par ailleurs, il peut être envisagé d'utiliser un seul bus de connexion 10 pour l'ensemble des deux capteurs.

Cette configuration permet de réduire fortement la taille globale de l'ensemble et favorise l'implantation de ce type de capteur de courant mixte 20 dans des déclencheurs électriques 40.

## Revendications

1. Capteur de courant mixte (20) comprenant un capteur magnétique de courant ayant un bobinage (23) enroulé autour d'un circuit magnétique (22), **caractérisé en ce qu'**il comporte un dispositif de mesure de courant comportant au moins trois bobinages (2) de type Rogowski reliés électriquement en série et formant un contour polygonal fermé disposé de manière à ce qu'un circuit primaire (7, 25) dudit capteur magnétique corresponde au circuit primaire (7, 25) dudit dispositif de mesure de courant (1), l'inductance locale d'au moins une des extrémités (A) desdits bobinages (2) étant supérieure à l'inductance locale vers la partie centrale (B) desdits bobinages

2. Capteur de courant mixte selon la revendication 1, **caractérisé en ce que** lesdits au moins trois bobinages (2) sont fixés sur une embase (5) munie d'un évidement central (6) permettant le passage dudit circuit primaire (7, 25), l'embase (5) étant constituée d'un circuit imprimé assurant à la fois la fixation mécanique des bobinages (2) et leur interconnexion électrique.

3. Capteur de courant mixte selon la revendication 2, **caractérisé en ce que** lesdits au moins trois bobinages (2) possèdent respectivement des picots de connexion (9) soudés directement sur le circuit imprimé.

4. Capteur de courant mixte selon la revendication 2 ou 3, **caractérisé en ce que** l'embase (5) comporte des moyens destinés à assurer des connexions externes desdits au moins trois bobinages (2) à un bus de connexion (10).

5. Capteur de courant mixte selon l'une des revendications 2 à 4, **caractérisé en ce que** l'embase (5) comporte des moyens destinés à assurer la connexion électrique du bobinage (23).

6. Capteur de courant mixte selon la revendication 5, **caractérisé en ce que** l'embase (5) comporte des moyens destinés à assurer des connexions externes de tous les bobinages (2, 23) à un seul bus de connexion (10).

7. Capteur de courant mixte selon l'une quelconque des revendications précédentes, **caractérisé en ce que** l'inductance locale aux deux extrémités (A) des bobinages (2) est supérieure à l'inductance locale vers la partie centrale (B) desdits bobinages.

8. Capteur de courant mixte selon l'une quelconque des revendications précédentes, **caractérisé en ce que** les extrémités (A) des bobinages (2) dont l'inductance locale est supérieure à l'inductance locale de la partie centrale (B) comportent un nombre de spires (8) de fil par unité de longueur supérieur au nombre de spires (8) de fil par unité de longueur vers la partie centrale (B) desdits bobinages.

9. Capteur de courant mixte selon la revendication 8 **caractérisé en ce que** les extrémités (A) comportent un nombre de couches de spires (8) de fil supérieur au nombre de couches de spires (8) de fil vers la partie centrale (B) desdits bobinages, le pas de l'enroulement des spires étant constant.

10. Capteur de courant mixte selon la revendication 8 **caractérisé en ce que** les extrémités (A) comportent, sur une même couche de spires (8), un pas d'enroulement des spires inférieur au pas de l'enroulement des spires vers la partie centrale (B) desdits bobinages.

11. Capteur de courant mixte selon l'une quelconque des revendications 8 à 10 **caractérisé en ce que** la variation du nombre de spires à chaque extrémité (A) des bobinages (2) est pratiquée sur une distance (D) comprise entre 10 et 20 pour cent de la longueur totale (L) du bobinage (2).

12. Capteur de courant mixte selon l'une quelconque des revendications 1 à 7, **caractérisé en ce que** les extrémités (A) des bobinages (2) dont l'inductance locale est supérieure à l'inductance locale de la partie centrale (B) comportent des spires de longueur supérieure à celle des spires vers la partie centrale (B) desdits bobinages.

13. capteur de courant mixte selon l'une quelconque des revendications précédentes **caractérisé en ce que** la surface radiale d'au moins une des extrémités (A) d'un bobinage (2) est partiellement recouverte par le bobinage adjacent.

14. Capteur de courant mixte selon l'une quelconque des revendications précédentes **caractérisé en ce qu'**il est constitué de quatre bobinages (2) agencés de façon à former un contour fermé.

15. Capteur de courant mixte selon la revendication 14, **caractérisé en ce que** le contour a une forme polygonale carrée ou rectangulaire.

16. Déclencheur électrique (40) comprenant des moyens de traitement (29) et un capteur de courant mixte selon l'une des revendications précédentes, **caractérisé en ce que** les moyens de traitement (29) sont connectés audit capteur de courant mixte pour recevoir au moins un signal représentatif d'un courant primaire.

17. Dispositif de coupure (50) comprenant un déclencheur électrique (40) selon la revendication 16 **caractérisé en ce qu'**il comporte un mécanisme d'ouverture (32) de contacts électriques (30) et un relais (31), ledit mécanisme étant relié au déclencheur (40).

## Claims

1. A mixed current sensor (20) comprising a magnetic current sensor having a coil (23) wound around a magnetic circuit (22), **characterized in that** it comprises a current measuring device comprising at least three Rogowski type coils (2) electrically connected in series and forming a closed polygonal outline arranged in such a way that a primary circuit (7, 25) of said magnetic sensor corresponds to the primary circuit (7, 25) of said current measuring device (1), the local inductance of at least one of the ends (A) of said coils (2) being greater than the local inductance towards the central part (B) of said coils.

2. The mixed current sensor according to claim 1, **characterized in that** said at least three coils (2) are fixed onto a base (5) provided with a central recess (6) for passage of said primary circuit (7, 25), the base (5) being formed by a printed circuit performing both mechanical fixing of the coils (2) and electrical interconnection of the latter.

3. The mixed current sensor according to claim 2, **characterized in that** said at least three coils (2) respectively have connecting pins (9) soldered directly onto the printed circuit.

4. The mixed current sensor according to claim 2 or 3, **characterized in that** the base (5) comprises means designed to make external connections of said at least three coils (2) to a connection bus (10).

5. The mixed current sensor according to one of claims 2 to 4, **characterized in that** the base (5) comprises means designed to perform electrical connection of the coil (23).

6. The mixed current sensor according to claim 5, **characterized in that** the base (5) comprises means designed to make external connections of all the coils (2, 23) to a single connection bus (10).

7. The mixed current sensor according to any one of the foregoing claims, **characterized in that** the local inductance at the two ends (A) of the coils (2) is greater than the local inductance towards the central part (B) of said coils.

8. The mixed current sensor according to any one of the foregoing claims, **characterized in that** the ends (A) of the coils (2) whose local inductance is greater than the local inductance of the central part (B) comprise a larger number of wiring turns (8) per unit length than the number of wiring turns (8) per unit length towards the central part (B) of said coils.

9. The mixed current sensor according to claim 8, **characterized in that** the ends (A) comprise a larger number of layers of wiring turns (8) than the number of layers of wiring turns (8) towards the central part (B) of said coils, the winding pitch of the turns being constant.

10. The mixed current sensor according to claim 8, **characterized in that**, on any one layer of turns (8), the ends (A) comprise a smaller winding pitch of the turns than the winding pitch of the turns towards the central part (B) of said coils.

11. The mixed current sensor according to any one of claims 8 to 10, **characterized in that** the variation of the number of turns at each end (A) of the coils (2) is made over a distance (D) comprised between 10 and 20 percent of the total length (L) of the coil (2).

12. The mixed current sensor according to any one of claims 1 to 7, **characterized in that** the ends (A) of the coils (2) which have a greater local inductance than the local inductance of the central part (B) comprise turns of greater length than that of the turns towards the central part (B) of said coils.

13. The mixed current sensor according to any one of the foregoing claims, **characterized in that** the radial surfaces of at least one of the ends (A) of a coil (2) is partially covered by the adjacent coil.

14. The mixed current sensor according to any one of the foregoing claims, **characterized in that** it is formed by four coils (2) arranged in such a way as to form a closed outline.

15. The mixed current sensor according to claim 14, **characterized in that** the outline has a square or rectangular polygonal shape.

16. An electric trip device (40) comprising processing means (29) and a mixed current sensor according to any one of the foregoing claims, **characterized in that** the processing means (29) are connected to said mixed current sensor to receive at least one signal representative of a primary current.

17. A switchgear device (50) comprising an electric trip device (40) according to claim 16 **characterized in that** it comprises an opening mechanism (32) of electric contacts (30) and a relay (31), said mechanism being connected to the trip device (40).

## Patentansprüche

1. Kombinierter Stromsensor (20) mit einem MagnetStromsensor, der eine, um einen Magnetkreis (22) geführte Wicklung (23) umfasst, **dadurch gekennzeichnet, dass** er eine Strommesseinrichtung mit mindestens drei als Rogowskispulen ausgebildeten, elektrisch in Reihe geschalteten und zu einem geschlossenen Vieleck angeordneten Wicklungen (2) umfasst, welche Einrichtung so ausgebildet ist, dass ein Primärstromkreis (7, 25) des genannten Magnetstromsensors dem Primärkreis (7, 25) der Strommesseinrichtung (1) entspricht, wobei die örtliche Induktivität mindestens eines der Enden (A) der genannten Wicklungen (2) größer ist als die örtliche Induktivität im Bereich des Mittelabschnitts (B) der genannten Wicklungen.

2. Kombinierter Stromsensor nach Anspruch 1, **dadurch gekennzeichnet, dass** die genannten mindestens drei Wicklungen (2) auf einem Grundkörper (5) befestigt sind, in dem eine Mittelöffnung (6) zur Durchführung des genannten Primärstromkreises ausgebildet ist, wobei der Grundkörper (5) als gedruckte Schaltung ausgebildet ist, die sowohl zur mechanischen Befestigung der Wicklungen (2) als auch zu deren elektrischer Verbindung dient.

3. Kombinierter Stromsensor nach Anspruch 2, **dadurch gekennzeichnet, dass** an den genannten mindestens drei Wicklungen (2) Verbindungsstifte (9) ausgebildet sind, die direkt auf die gedruckte Schaltung gelötet werden.

4. Kombinierter Stromsensor nach Anspruch 2 oder 3, **dadurch gekennzeichnet, dass** der Grundkörper (5) Mittel umfasst, die dazu dienen, die äußeren Anschlussverbindungen der genannten mindestens drei Wicklungen (2) mit einer Verbindungsbusleitung (10) zu gewährleisten.

5. Kombinierter Stromsensor nach einem der Ansprüche 2 bis 4, **dadurch gekennzeichnet, dass** der Grundkörper (5) Mittel umfasst, die dazu dienen, die elektrische Anschlussverbindung der Wicklung (23) zu gewährleisten.

6. Kombinierter Stromsensor nach Anspruch 5, **dadurch gekennzeichnet, dass** der Grundkörper (5) Mittel umfasst, die dazu dienen, die äußeren Anschlussverbindungen aller Wicklungen (2, 23) mit einer einzigen Verbindungsbusleitung (10) zu gewährleisten.

7. Kombinierter Stromsensor nach irgendeinem der vorhergehenden Ansprüche, **dadurch gekennzeichnet, dass** die örtliche Induktivität an den beiden Enden (A) der Wicklungen (2) größer ist als die örtliche Induktivität im Bereich des Mittelabschnitts (B) der genannten Wicklungen.

8. Kombinierter Stromsensor nach irgendeinem der vorhergehenden Ansprüche, **dadurch gekennzeichnet, dass** an den Enden (A) der Wicklungen (2), an denen die örtliche Induktivität größer ist als im Mittelabschnitt (B), die Anzahl von Drahtwindungen (8) pro Längeneinheit größer ist als die Anzahl von Drahtwindungen (8) pro Längeneinheit im Mittelabschnitt (B) der genannten Wicklungen.

9. Kombinierter Stromsensor nach Anspruch 8, **dadurch gekennzeichnet, dass** bei konstantem Wicklungsschritt die Anzahl der Lagen von Drahtwindungen (8) an den Enden (A) größer ist als die Anzahl der Lagen von Drahtwindungen (8) im Bereich des Mittelabschnitts (B) der genannten Wicklungen.

10. Kombinierter Stromsensor nach Anspruch 8, **dadurch gekennzeichnet, dass** in einer gleichen Lage von Windungen (8) der Wicklungsschritt der Windungen an den Enden (A) kleiner ist als der Wicklungsschritt der Windungen im Bereich des Mittelabschnitts (B) der genannten Wicklungen.

11. Kombinierter Stromsensor nach Anspruch 8 bis 10, **dadurch gekennzeichnet, dass** die Änderung der Windungszahl an jedem Ende (A) der Wicklungen (2) über eine Länge (D) zwischen 10 und 20 Prozent der Gesamtlänge (L) der Wicklungen (2) erfolgt.

12. Kombinierter Stromsensor nach irgendeinem der Ansprüche 1 bis 7, **dadurch gekennzeichnet, dass** an den Enden (A) der Wicklungen (2), an denen die örtliche Induktivität größer ist als im Mittelabschnitt (B), die Windungen eine größere Länge aufweisen (8) als die Windungen im Bereich des Mittelabschnitts (B) der genannten Wicklungen.

13. Kombinierter Stromsensor nach irgendeinem der vorhergehenden Ansprüche, **dadurch gekennzeichnet, dass** die radiale Oberfläche mindestens eines der Enden (A) einer Wicklung (2) teilweise von der angrenzenden Wicklung überdeckt wird.

14. Kombinierter Stromsensor nach irgendeinem der vorhergehenden Ansprüche, **dadurch gekennzeichnet, dass** er aus vier Wicklungen (2) besteht, die so angeordnet sind, dass sie eine geschlossene Form ergeben.

15. Kombinierter Stromsensor nach Anspruch 14, **dadurch gekennzeichnet, dass** die Form ein Quadrat oder Rechteck darstellt.

16. Elektrischer Auslöser (40) mit Verarbeitungsmitteln (29) und einem kombinierten Stromsensor nach einem der vorhergehenden Ansprüche, **dadurch gekennzeichnet, dass** die Verarbeitungsmittel (29) mit dem genannten kombinierten Sensor verbunden sind, um mindestens ein Signal zu empfangen, das einen Primärstrom abbildet.

17. Schaltgerät (50) mit einem elektrischen Auslöser (40) nach Anspruch 16, **dadurch gekennzeichnet, dass** es einen Abschaltmechanismus (32) zur Abschaltung von elektrischen Kontakten (30) sowie ein Relais (31) umfasst, welcher Mechanismus mit dem Auslöser (40) verbunden ist.
